# EUROPEAN PATENT APPLICATION

(11) **EP 1 033 271 A1**
(43) Date of publication of application: **06.09.2000**
(21) Application number: 00301779.5
(22) Date of filing: 03.03.2000
(51) Int. Cl.: B60J 7/057, E05F 15/00, H03K 17/945, G08B 13/24

(54) **Microwave proximity sensor**

(30) Priority: 04.03.1999 GB 9905030
(71) Applicant: Dynex Semiconductor Limited, Oxon, RG9 2JR (GB)
(72) Inventor: Redfern, Stephen William, Eagle, Lincoln LN6 9DJ (GB); Tyson, Paul Andrew, Doddington Park, Lincoln LN6 0NY (GB); Blunden, Peter Philip, Reepham, Lincoln LN3 4EB (GB)
(74) Representative: Pratt, David Martin

(57) **Abstract**

A sensor arrangement, for detecting the presence of an object such as a human hand, in the aperture of a powered window, sunroof or the like includes a balanced transmission line 31,32 associated with the aperture. The transmission line is fed with microwave frequency signals from an oscillator 10, which signals are modulated with signals from an oscillator 61, via a balun 62. Signals received from the transmission line 31,32 are filtered by a filter 95 to isolate signals at the modulation frequency, and the resulting signal is subsequently applied to a window comparator 98. A detection signal is provided when an object is detected near to the transmission line 31,32. The detection signal is used to control the powered window, sunroof etc. accordingly.

## Description

The present invention relates to a sensor arrangement for detecting the presence of part of the human body or other object in the proximity of a powered window, sunroof and the like.

Vehicles are commonly fitted with electrically-powered windows and sunroofs. These are increasingly often found with some kind of control system which is intended to protect the vehicle against damage, and to protect people against personal injury when becoming trapped as the window or sunroof closes. Presently available systems fall into one of three classes.

Firstly, there are systems which include a pressure transducer in the vicinity of the window or sunroof, the pressure transducer being arranged to detect an object being pressed against it. A transducer can take the form of a resistive strip, a fluid-containing conduit or an elongate electrical contact switch supported adjacent to the aperture formed by the window or sunroof, such as on the window or sunroof frame. Secondly, there are systems which include electronics which examine the electric current driving the motor or motors of the powered window or sunroof to detect when the motor or motors stall.

Both of these types of system suffer the disadvantage that some force is required before the system will provide a detection to control the powering of the window or sunroof. This force will usually be provided by the resistance to crushing of an object in the way of the closing window. This is clearly undesirable, as the object or the window may be damaged before the window or sunroof is controlled to be stopped. It is difficult to pass the force-displacement parameters of the US FMVSS 118 specification with such contact systems.

Thirdly, it is known to provide plural conductors near a window aperture, usually on a window edge, and to detect a change in the frequency of an oscillator supplying energy to the conductors to infer that the capacitance between the conductors has changed due to the presence of a body part or the like. Such capacitance sensing arrangements have the disadvantage that they are susceptible to changes in moisture, and to the influx of dirt or debris, rendering them not wholly reliable. Techniques for improving the reliability of such arrangements are known, but these tend to be complicated and, therefore, expensive. Furthermore, such arrangements often require the printing of conductors onto the glass of the window, which further increases the expense.

In accordance with the present invention, there is provided a sensor arrangement for detecting the presence of an object in the proximity of an aperture for housing a powered window, sunroof or the like, the arrangement comprising:
a balanced transmission line operatively associated with the aperture;
a generating means for supplying the transmission line with microwave frequency signals; and
circuit means electrically connected to receive signals from the antenna, and arranged to provide a detection signal on detection of an object in the proximity of or touching the antenna.

The object may be part of a human body or may be any other object. The transmission line may be associated with the window or sunroof, or may be associated with the frame in which a window or sunroof is supported, for example.

Embodiments of the present invention will now be described, by way of example only, with reference to the accompanying drawings, in which:-
Figures 1, 4, 5 and 7 are schematic diagrams of sensor circuits suitable for use with a sensor arrangement in accordance with this invention;
Figures 2A, 2B and 3 are schematic diagrams of antenna arrangements suitable for use with a sensor arrangement in accordance with this invention;
Figure 6 is a diagram of a quartz crystal resonator, used in one embodiment of the invention; and
Figure 8 is a diagram of a balun used in one embodiment of the invention.

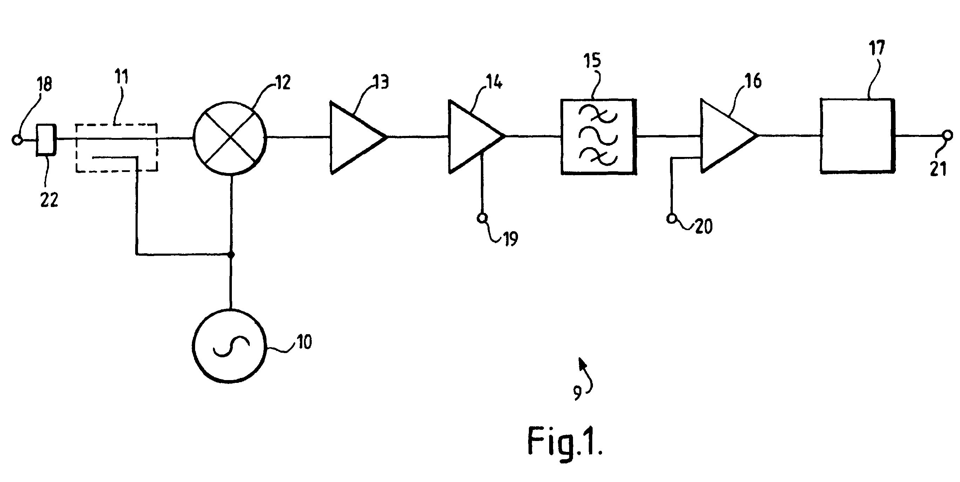

Referring to the drawings, Figure 1 shows a sensor circuit 9 generally comprising an oscillator 10, an RF coupler 11, a mixer 12, a fixed-gain amplifier 13, a controllable gain amplifier 14, a band pass filter 15, a threshold comparator 16 and a logic element 17. The oscillator 10 generates microwave frequency signals, in this example at 27 MHz at a power of about 1mW. Of course, 418 MHz, 433.92 MHz, 2.45 GHz or any other suitable frequency could be used. These signals are applied to a balanced transmission line (not shown in Figure 1) connected, via a balun 22 and a coupler 11, to a terminal 18. The mixer 12 mixes the microwave signals provided by the oscillator 10 with signals received from the antenna via the terminal 18, the balun 22 and the coupler 11 to provide a mixed signal to the amplifier 13. The amplifier 14 amplifies further the amplified mixed signal provided by the amplifier 13 with a gain which is dependent on a gain control signal received on a gain control terminal 19. The resultant signal is filtered by the filter 15 so as to remove both signals which are near to zero frequency and signals which are above a predetermined frequency. This predetermined frequency is chosen such that signals which are higher in frequency are likely to be caused only by noise or other external interference. The filtered signal thus resulting is applied to a comparator 16, where the amplitude of the filtered signal is compared with a threshold provided at a threshold setting terminal 20. Where the threshold is exceeded, a high output signal is provided to the logic element 17. The logic element 17 controls a motor control regulator (not shown) by way of an output terminal 21 dependent on the signal provided by the comparator 16.

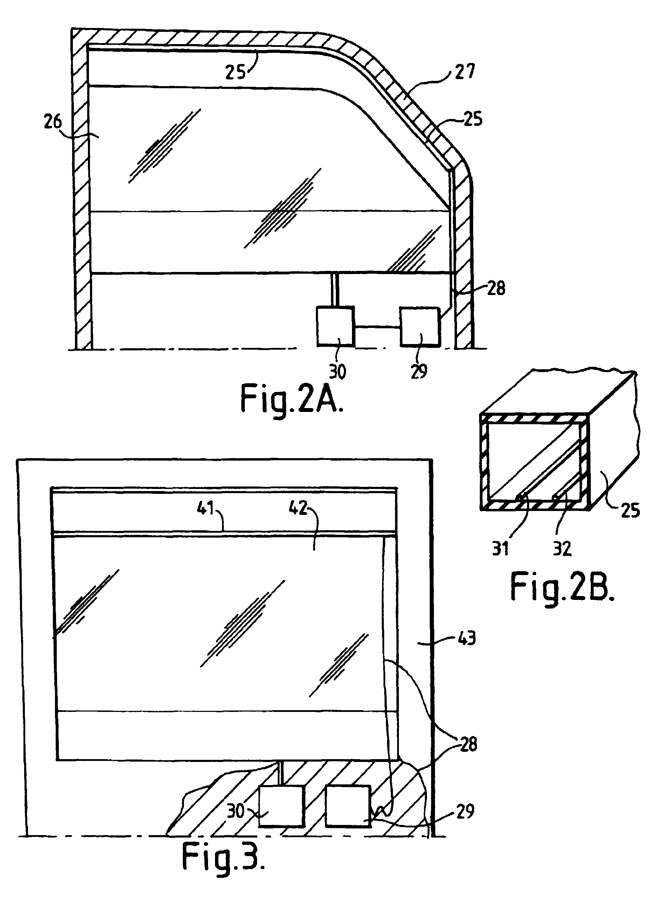

Referring now to Figures 2A and 2B, the balanced transmission line (formed by first and second conductors 31 and 32) is positioned in a rubber window seal 25 located along the lowermost edge of the upper part of a vehicle door 27. A glass window 26 is supported for movement in the door 27. The conductors 31 and 32 of the transmission line are secured to a floor of the window seal 25 by an adhesive. The balanced transmission line thus comprises a mechanically-symmetrical arrangement of two parallel conducting wires 31 and 32. A constant separation of the wires 31 and 32 is obtained by setting the wires in a support made of plastics material. The wires 31 and 32 are separated by a distance of 1.7 mm, which gives the transmission line an impedance of 200 Ω when wires of diameter 0.05 mm are used. The distal ends of the wires 31 and 32 are connected together by a resistive impedance of 200 Ω. The output of the impedance of the oscillator 10 is matched to the real part of the impedance of the transmission line 31, 32. Since the transmission line 31, 32 is fed from a balanced feed, the electrical and magnetic fields around the wires 31 and 32 cancel, resulting in very little energy being lost by radiation. Since the transmission line 31, 32 is a low impedance structure, it is substantially insensitive to the effects of moisture and dirt. The transmission line 31, 32 allows the transfer of power without reflection. Also, this arrangement allows the transmission line 31, 32 to be kept at a uniform distance from the metallic window frame 27, which serves as a ground plane. Of course, the invention is not limited to this particular impedance or these particular dimensions. However, for optimum sensor arrangement performance, it is preferred that conductor and dielectric losses of the transmission line 31, 32 are minimised.

The balanced transmission line 31, 32 forms an antenna which, when supplied with RF signals, sets up an RF field in a volume surrounding the whole of its length. The transmission line 31, 32 is connected by an RF feed cable 28 to a control circuit 29, which includes the circuit 9 of Figure 1 and a motor control regulator. The window 26 is moved in the door 27 by an electric motor 30, which is controlled by the control circuit 29.

In operation, the oscillator 10 provides the transmission line 31, 32 with 27 MHz signals at a power of approximately 1mW. This causes an RF field to be set up around the transmission line (antenna) 31, 32 to a distance of up to 2cm. Under normal circumstances, the mixer 12 will receive, from the transmission line 31, 32, signals at the same frequency as those provided by the oscillator 10. The output of the mixer 12 will thus show a signal having a de component but no significant ac components. As de components are filtered out by the filter 15, only low amplitude signals will be provided to the comparator 16, which will not, therefore, provide a high output signal to the logic element 17. The motor control circuit 29 will be free, therefore, to control movement of the window 26 as normal.

Movement of an object, for example a human hand, in the RF field surrounding the transmission line 31, 32, causes a disturbance in that field and the impedance of the transmission line to be altered. This disturbance causes a change in the oscillation frequency of the oscillator 10, which causes a change in the frequency of the electrical signals carried on the transmission line 31, 32. The mixer 12 then, because it mixes the signals provided by the oscillator 10 with the signals provided by the transmission line 31, 32, provides an output signal having significant but low frequency and low amplitude ac components to the amplifier 13. This signal is amplified by the amplifiers 13 and 14 and provided to the filter 15, which removes the de components. The comparator 16, on detecting that the amplitude of the filtered signals exceeds the threshold provided at the terminal 20, provides a logical high output signal to the logic element 17, which thereby provides a logic signal on the output terminal 21 indicative of there being an object in the proximity of the transmission line 31, 32 and therefore the top edge of the window 26. The control circuit 29 then controls the motor 30 accordingly.

It will be appreciated that the system described above is able to detect the presence of an object, such as a human hand, in the region between the window 26 and the top of the door frame without any force being provided against either of these items. Significantly, no crushing needs to be experienced before movement of the window 26 is controlled to be stopped. If it is required to use the sensor arrangement of Figure 2A in a vehicle, such as a convertible car, having frameless doors, the transmission line may be mounted in the vehicle's roof.

Figure 3 shows a sensor arrangement according to the invention. Reference numerals are retained from Figure 2A for like elements. In Figure 3, a transmission line 41 is formed by metallisation on the leading edge of the glass 42 of a sunroof. The glass 42 is powered by the motor 30 to slide longitudinally in a frame 43 provided in the roof of the vehicle. The sensor arrangement includes a control circuit 29, which operates in the same way as the control circuit described above.

Because the Figure 1 sensor circuit relies on frequency pulling of the oscillator 10 for object detection, the sensor circuit is sensitive only to objects moving near to the transmission line 31, 32. As a large proportion of situations which may result in an object being trapped in a closing window or sunroof are likely to involve moving objects, the Figure 1 sensor circuit will be sufficient for most situations. Where, however, detection of objects which remain stationary relative to the transmission line 31, 32 is required, the sensor arrangement must be modified.

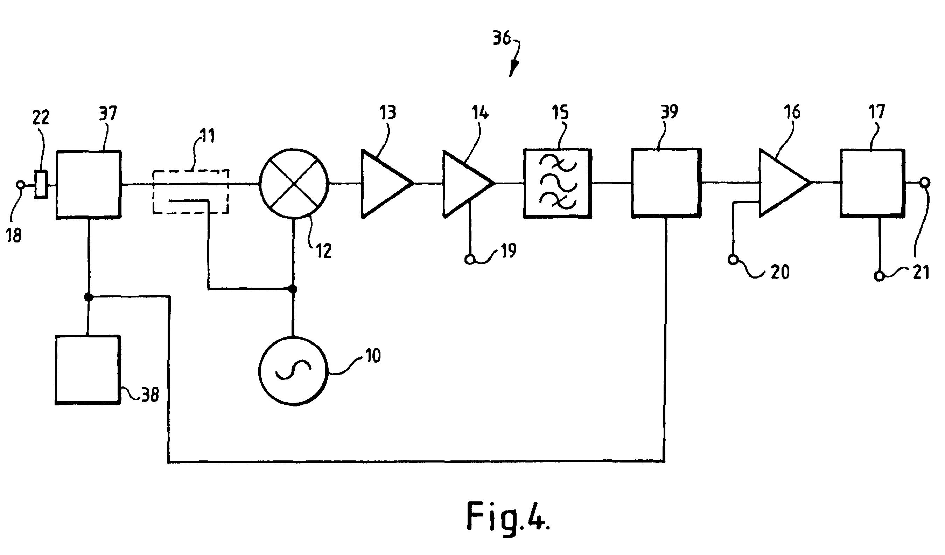

In Figure 4, in which reference numerals have been retained for from previous Figures for like elements, a sensor circuit 36 further includes a phase shifter 37, phase shifter switching circuitry 38 and a synchronous detector 39. The synchronous detector 39 is interposed between the filter 15 and the comparator 16. The phase shifter switching circuitry 38 is connected to provide phase shift control signals to both the phase shifter 37 and the synchronous detector 39.

The circuitry 38 provides phase shift control signals that cause the phase shifter 37 to sweep the phase of the signals applied to the transmission line 31, 32 between 0° and 180°. The phase shifter 37 in effect modulates the signal applied to the terminal 18. As the synchronous detector 39 is sensitive only to signals which are in phase with those provided by the phase shift control circuitry 38, the sensor circuit 36 is sensitive also to stationary objects near to the transmission line 31, 32. The use of the phase shifter 37 alters the effective phase length of the transmission line 31, 32. This has the effects of substantially eliminating standing wave nulls, and of generating a different signal level at the output of the synchronous detector 39 if objects are proximate to the transmission line 31, 32.

The inventors are aware that, when a transmission line is mounted on or near to the leading edge of a window or sunroof, certain problems may be encountered, as the leading edge passes into or out of boundaries of the aperture formed by the door frame or vehicle roof, as the case may be. In particular, the close proximity of the (usually) metallic vehicle roof or door frame to the antenna could cause the sensor circuit 9 or 36 to provide a detection output signal. This applies both to fully-open and to fully- closed windows and sunroofs.

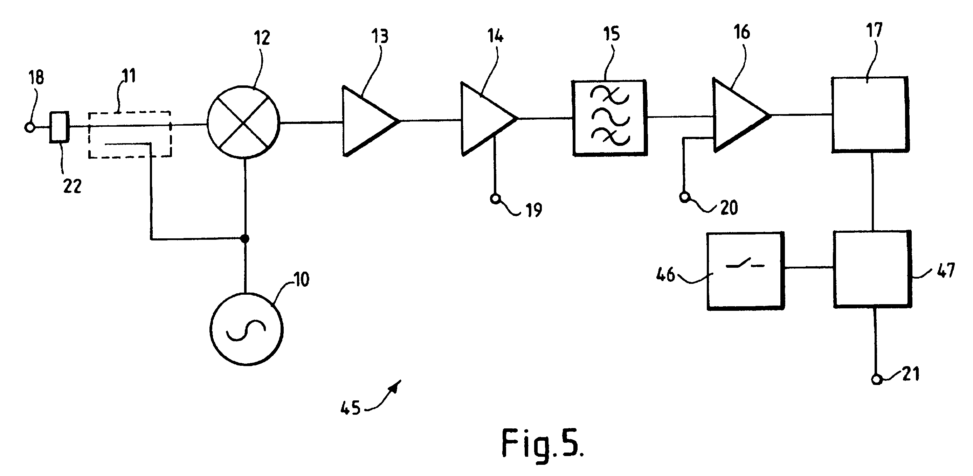

Referring now to Figure 5, a modified sensor circuit 45 is proposed to overcome this problem. The sensor circuit 45 comprises, in addition to the sensor circuit 9 of Figure 1, from which reference numerals have been retained for like elements, a switch 46 and an AND gate 47. The logic element 17 and the switch 46 are connected to different inputs of the AND gate 47; and the output terminal 21 is connected to the output of the AND gate instead of to the output of the logic element 17. The switch 46 is arranged to detect that the window or sunroof is near to either end of the positions between which it is movable, and to provide a logic zero signal to mute the output of the logic element 17 on such a detection.

The switch 46 may include, for the purpose of window or sunroof position detection, an optical switch, one or more microswitches, a Hall effect sensor, a stepping motor drive, a reed switch or any other suitable device. Preferably the switch 46 is mounted such that it operates only when the gap between the window or sunroof and the associated aperture is so small (less than 4 mm) or so inaccessible that there is no danger of trapping.

Instead of the control circuit 29 being mounted in a fixed position relative to the door or vehicle roof, mounting of the circuit 45 on the window or sunroof may be preferred. In this case, the control circuit 29 may still be mounted out of sight within the door frame or vehicle roof, but the RF feed cable 28 between the transmission line (antenna) 31, 32 and the control circuit 29 does not need to be flexible. Also, it may not be necessary to provide window or sunroof position detection transducers for the position of the window or sunroof to be detected.

The sensitivity of any of the sensor circuits 9, 36 and 45 may be adjusted either by adjustment of the gain of the amplifier 14, or by adjustment of the threshold provided at the terminal 20.

The frequencies of operation mentioned above correspond to frequencies for which RF type approval as a short range device is possible. Such frequencies are permitted by international regulations. A lower frequency is preferred, since high frequencies result in increased line loss. A lower line loss allows more consistent detection of objects near to the transmission line 31, 32. Also, if the transmission line 31, 32 is, or becomes, mis-matched for any reason, standing waves can result. The use of a lower frequency reduces the risk of standing waves occurring, particularly if the transmission line 31, 32 is only a fraction of the wavelength of the signals, and negative detection effects caused by standing waves are thereby substantially eliminated.

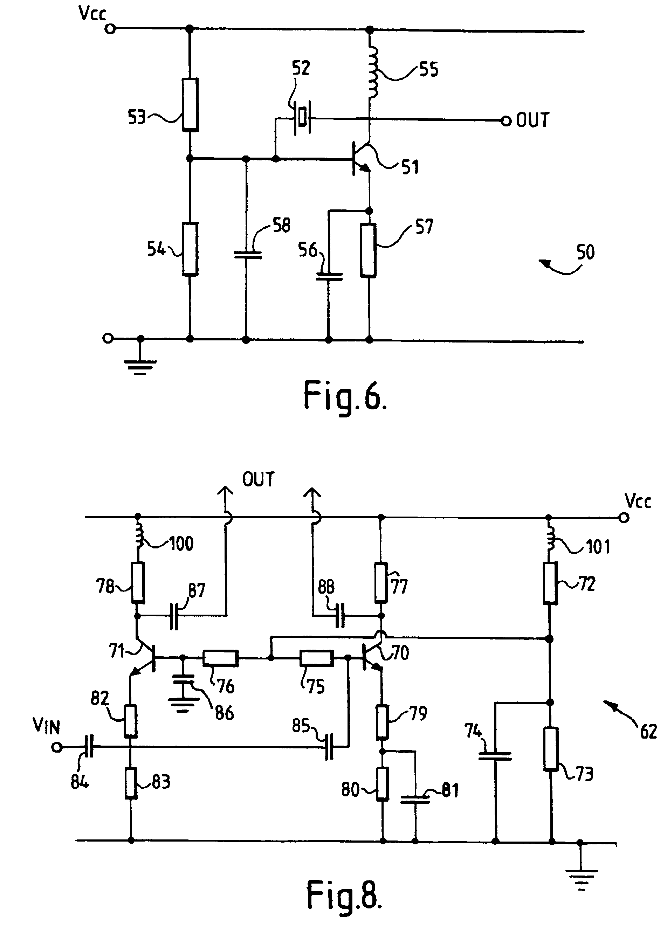

The frequency of the oscillator 10 may need to be stabilised to comply with the above-mentioned type approval regulations. This can be achieved by using a phase-locked loop, a ceramic resonator, a surface acoustic wave (SAW) resonator or a crystal oscillator. Each has benefits and disadvantages, although the choice depends particularly on the frequency of operation of the sensor arrangement. A preferred implementation uses a quartz crystal resonator arranged as shown in Figure 6.

Referring to Figure 6, an oscillator circuit 50, in the form of a Colpitts oscillator, is shown comprising a bipolar transistor 51 and a quartz crystal 52. The base electrode of the transistor 51 is biased by a potential divider formed by resistors 53 and 54 connected in series between the supply voltage and ground. An inductor 55 connects the collector electrode of the transistor 51 to the supply voltage. A capacitor 56 and a resistor 57 are connected in parallel between the emitter electrode of the transistor 51 and ground. A second capacitor 58 is connected between the base electrode of the transistor 51 and ground. The quartz crystal 52 is connected in the feedback path of the transistor 51, which thereby provides a stabilised output signal at its collector electrode.

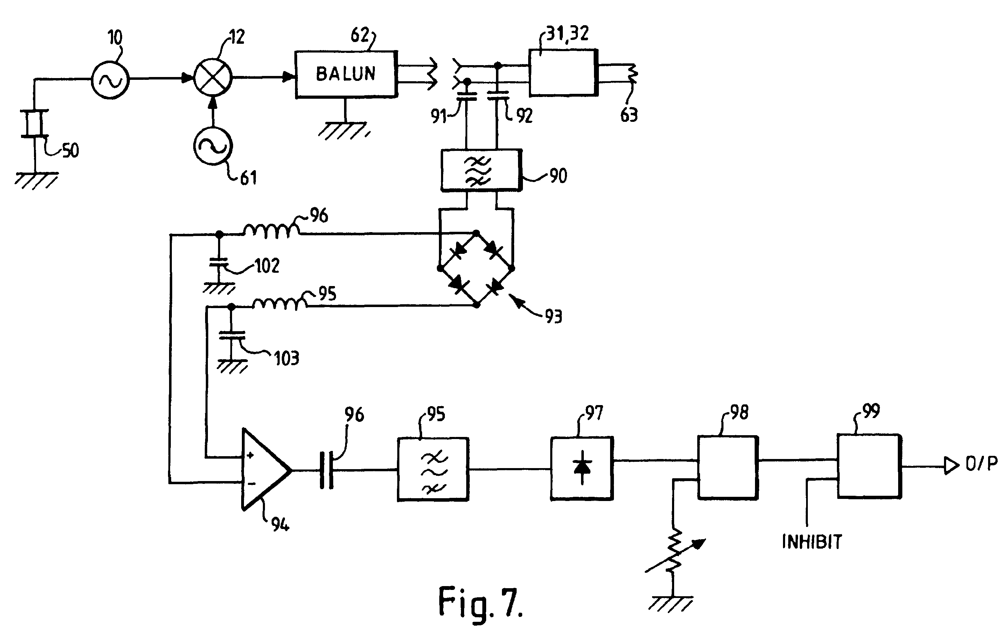

A preferred sensor arrangement 60 is shown in Figure 7. Referring to Figure 7, the arrangement 60 comprises an oscillator 10, stabilised by the Figure 6 quartz crystal resonator 50, arranged to provide 27 MHz signals to a mixer 12. The mixer 12 is also supplied with signals from a modulating oscillator 61. This arrangement applies 10 Khz amplitude modulation to the signal supplied by the oscillator 10. The modulated signal is supplied to a balun 62, which supplies a balanced signal onto the transmission line 31, 32. An impedance 63 terminates the conductors at the transmission line 31, 32. The balun 62 is shown in greater detail in Figure 8.

Referring to Figure 8, the balun 62 comprises generally a pair of base-coupled bipolar transistors 70, 71. The transistors 70, 71 may form part of a BFS480 or a SOT235 package. A potential divider, formed by resistors 72, 73, is connected between the supply voltage and ground. A capacitor 74 is connected in parallel to the resistor 73. The base electrodes of the transistors 70, 71 are connected to the connection of the resistors 72, 73 by respective resistors 75, 76. The collector electrodes of the transistors 70, 71 are connected to the supply voltage by respective resistors 77, 78 and inductors 100, 101. The emitter electrode of the transistor 70 is connected to ground by series-connected resistors 79, 80. A capacitor 81 is connected across the resistor 80. The emitter electrode of the transistor 71 is connected to ground by series-connected resistors 82, 83. The node between the resistors 82, 83 receives the input signal V_{IN} from the mixer 12 by a further capacitor 84, and is connected to the base electrode of the transistor 70 by a still further capacitor 85. The base electrode of the transistor 71 is connected to ground by a further capacitor 86.

The balun 62 therefore provides balanced differential outputs from the collector electrodes of the transistors 70, 71, via de blocking capacitors 87, 88, from an unbalanced single-ended input signal. Interference rejection is improved where a balanced signal is used on the transmission line 31, 32, since common mode signals are rejected. Of course, it may be preferred to design the sensor circuit in a fully-balanced way, so that a balun is not required. Such an approach usually involves additional complexity, although this is not a significant penalty if the circuit is fully integrated onto silicon.

Referring again to Figure 7, a 27 MHz bandpass filter 90 is connected to the conductors of the transmission line 31, 32 by respective de blocking capacitors 91, 92. The filtering further increases immunity to interference. Output signals from the filter 90 are supplied to a diode bridge 93 which is a balanced structure and serves to rectify the RF signals taken from the transmission line 31, 32. The output signal consists of rectified versions of the 27 MHz carrier and the 10 Khz modulation signals. The differential output signal supplied by the diode bridge 93 is coupled to respective inputs of a differential amplifier 94 by respective inductors 95, 96, and capacitors 102, 103, forming a low pass filter. The amplifier 94 amplifies both the ac and the dc components of the output signals of the diode bridge 93, and supplies the amplified signal to a 10 Khz bandpass filter 95 via a de blocking capacitor 96. The filter 95 provides an output signal having components only at, or around, the 10 Khz modulation frequency. These signals are then rectified by a diode rectifier 97, which serves as an envelope detector to produce a de signal, which may or may not be integrated over time. This de signal is provided to an input of a window comparator 98. The window comparator 98 is provided with upper and lower thresholds, which are both pre-set. The output of the comparator 98 is supplied to a logic gate 99, which inhibits the circuit output when it is detected that the window is nearly closed.

The presence of a body part near to the transmission line 31, 32 causes an imbalance in the line which results in standing waves being set up. This causes an amplitude change in the signals, which is rectified by the diode bridge 93 and amplified by the amplifier 94. If the amplitude change is sufficient, the window comparator 98 detects that its input signal exceeds its upper threshold or drops below its lower threshold, and provides an indicative output signal. This is then received by the motor control unit 29, and the window is controlled to be stopped, or preferably reversed.

To determine what thresholds the comparator 98 needs to be provided with, and what bandwidth the filter 95 needs to have, for optimum performance, the filter 95 is disconnected from the capacitor 96. The output of the capacitor 96 is connected to a Fast Fourier Transform (FFT) analyser, and the spectrum of signal returns is observed as a body part is moved near to the transmission line 31, 32. From observing the spectrum, the bandwidth of the output signals is taken to be the required bandwidth for the filter 95. The thresholds of the comparator 98 are selected so as to ensure that the sensor circuit is triggered when a body part is present near to the transmission line 31, 32 whilst minimising the possibility of false detection. Of course, this sensor arrangement fails safely, since false detections result in the motor 30 being stopped or reversed.

Instead of amplitude modulation being applied to the oscillator 10, frequency modulation or digital modulation could be used. A pseudo random code could be used to phase modulate the signal, with de-correlation against the code occurring in the detection circuitry. Use of a pseudo random code in this way provides increased immunity to interference, although the arrangement required is more complicated than the amplitude modulated arrangement described.

As well as being applicable to automotive windows or sunroofs, this invention could be used with motorised doors or trunks, and non-automotive applications such as lift or elevator doors.

## Claims

1. A sensor arrangement for detecting the presence of an object in the proximity of an aperture for housing a powered window, sunroof or the like, the sensor arrangement comprising:-
at least one balanced transmission line operatively associated with the aperture;
a generating means for supplying the transmission line with microwave frequency signals; and
circuit means electrically connected to receive signals from the transmission line and arranged to provide a detection signal on detection of an object in the proximity of or touching the antenna.

2. A sensor in accordance with claim 1, in which the circuit means comprises mixing means to mix the microwave frequency signals supplied by the generating means with the signals received from the transmission line.

3. A sensor in accordance with claim 2, further comprising means to shift the phase of the microwave frequency signals applied to the transmission line by an amount dependent on a phase shifting signal; and a synchronous detector arranged to receive signals from the mixing means and to receive the phase shifting signals.

4. A sensor in accordance with claim 2 or claim 3, in which the output of the mixing means or the synchronous detector respectively is connected to a threshold comparator, the output of which provides said detection signal.

5. A sensor in accordance with claim 4, in which the threshold corporator is a window comparator.

6. A sensor in accordance with any preceding claim, further comprising control means to provide a control signal to control the powered window, sunroof or the like, the control signal being dependent on the detection signal.

7. A sensor in accordance with claim 6, further comprising position detecting means to detect the position of the window, sunroof or the like, the control signal being dependent also on the output of the position detecting means.

8. A sensor in accordance with any preceding claim, in which the transmission line is formed on a surface or surfaces of the powered window, sunroof or the like.

9. A sensor in accordance with any preceding claim, in which the generating means includes a Colpitts oscillator.

10. A sensor in accordance with any preceding claim, in which a balun is connected between the generating means and the transmission line.

11. A sensor in accordance with any preceding claim, further comprising means to modulate the microwave frequency signals with modulating signals prior to the signals being supplied to the transmission line.

12. A sensor in accordance with claim 11, in which the circuit means includes means to attenuate signals received from the transmission line other than signals at or around the frequency of the modulating signals.

13. A sensor in accordance with claim 11 or claim 12, in which the modulating means are amplitude modulating means.

14. A sensor in accordance with claim 11, in which the modulating means includes means to mix the microwave frequency signals with a pseudo-random code.
